# FASCICULE DE BREVET EUROPEEN

(11) **EP 3 060 524 B1**
(45) Date de publication et mention de la délivrance du brevet: **19.09.2018**
(21) Numéro de dépôt: 14828450.8
(22) Date de dépôt: 21.10.2014
(51) Int. Cl.: C01G 41/00, C01G 41/02

(54) **COMPOSE DE TYPE OXYDE DE TUNGSTENE PRESENTANT UNE NOUVELLE STRUCTURE CRISTALLINE ET SON PROCEDE DE PREPARATION**
WOLFRAMOXIDVERBINDUNG MIT EINER NEUEN KRISTALLINEN STRUKTUR UND VERFAHREN ZUR HERSTELLUNG DAVON
TUNGSTEN OXIDE-TYPE COMPOUND HAVING A NEW CRYSTALLINE STRUCTURE AND METHOD FOR PREPARING SAME

(30) Priorité: 22.10.2013 FR 1302438
(43) Date de publication de la demande: 31.08.2016
(73) Titulaire: Rhodia Operations, 75009 Paris (FR); Centre National de la Recherche Scientifique (C.N.R.S.), 75016 Paris (FR); Université Pierre et Marie Curie, 75005 Paris (FR)
(72) Inventeur: BUISSETTE, Valérie, F-75015 Paris (FR); LE MERCIER, Thierry, F-93110 Rosny Sous Bois (FR); BESNARDIERE, Julie, F-75014 Paris (FR); CASSAIGNON, Sophie, F-92160 Antony (FR); PORTEHAULT, David, F-94270 Le Kremlin-Bicêtre (FR); WALLEZ, Gilles, F-92130 Issy-les-Moulineaux (FR)
(74) Mandataire: Senninger, Thierry
(86) Numéro de dépôt international: PCT/EP2014/072523
(87) Numéro de publication internationale: WO 2015/059127

(56) Documents cités:
- WO-A1-02/096559
- GENIN C ET AL: "Hydrogen bronzes of new oxides of the WO3-MoO3 system with hexagonal, pyrochlore and ReO3-type structures", SOLID STATE IONICS, NORTH HOLLAND PUB. COMPANY. AMSTERDAM; NL, NL, vol. 53-56, 1 juillet 1992 (1992-07-01), pages 315-323, XP024711370, ISSN: 0167-2738, DOI: 10.1016/0167-2738(92)90394-5 [extrait le 1992-07-01]
- J ZHAN ET AL: "A solvothermal route for the synthesis of ammonium tungsten bronze", SOLID STATE IONICS, vol. 126, no. 3-4, 2 novembre 1999 (1999-11-02), pages 373-377, XP055131006, ISSN: 0167-2738, DOI: 10.1016/S0167-2738(99)00250-7

## Description

La présente invention concerne un composé de type oxyde de tungstène présentant une nouvelle structure cristalline ainsi que son procédé de préparation.

Les oxydes de tungstène ont été largement décrits dans la littérature, sous forme de composés WO₃ stoechiométriques ou sous-stoechiométriques, cristallisés ou non. Les oxydes de tungstène sont utiles dans de nombreuses applications techniques telles que les dispositifs électrochromes, les supercondensateurs, les batteries ou même les photocatalyseurs dans le domaine du visible.

Pour ces applications on estime qu'il est important que la structure de ces oxydes puisse présenter des espaces entre les atomes constitutifs de l'oxyde permettant éventuellement une insertion à l'intérieur de cette structure de cations comme notamment le lithium ou le sodium.

Pour exemple WO 02/096559 décrit des compositions d'oxyde métallique présentant la formule empirique: A_{x/n}[B_{y}M_{1-y}O_{3,δ}]^{x}ZH₂O, dans laquelle M représente au moins un métal du groupe Vb ou Vlb; A représente un cation sélectionné dans le groupe comprenant les métaux alcalins, les métaux alcalino-terreux, l'argent, l'ammonium, l'hydrogène et leurs mélanges; B représente au moins un élément sélectionné dans le groupe comprenant W, Zr, Mo, V, Ti, Fe, Ce, Sb, Nb, Mn, Co, Cr, Fe, Ta, Sn et Cu, à condition que M et B soient différents; y est un nombre compris entre 0 et 3; et 3+δ indique la stoechiométrie de l'oxygène, ces compositions servant à retirer, au moins partiellement, des cations d'au moins un métal sélectionné dans le groupe comprenant le césium, le strontium, le plomb, l'argent, les métaux de transition, les lanthanides et les actinides, présents dans un liquide.

L'objet de l'invention est de fournir un composé dont la structure présente des espaces encore plus accessibles que ceux présents dans la structure des oxydes de tungstène connus.

Dans ce but, le composé de l'invention est un composé de formule (1) AₓW_{1-y}Mo_{y}O₃ dans laquelle A est choisi dans le groupe comprenant les cations Li, Na, NH₄, K et H, et il est caractérisé en ce que x et y vérifient les relations 0 ≤ x ≤ 1 et 0 ≤ y ≤ 0,5 et en ce qu'il présente une structure cristalline de type hexagonal et à base d'octaèdres WO₆, ladite structure présentant des tunnels délimités par 6, 4 et 3 desdits octaèdres et orientés selon l'axe c.

J. Zhan et al., Solid State Ionics, 126 (1999), 373-373 and Genin et al., Solid State Ionics, 53-56 (1992), 315-323 décrivent des bronzes de tungstène hexagonal. La présence des tunnels délimités par 6, 4 et 3 octaèdres WO₆ et orientés selon l'axe c dans la structure cristalline des bronzes n'est pas décrite.

D'autres caractéristiques, détails et avantages de l'invention apparaîtront encore plus complètement à la lecture de la description qui va suivre faite en référence aux dessins annexés et dans lesquels :
- la figure 1 est un schéma illustrant la structure cristalline d'un produit selon l'art antérieur;
- la figure 2 est un schéma illustrant la structure cristalline d'un produit selon l'invention;
- la figure 3 est un diagramme RX d'un produit selon l'invention;
- la figure 4 est un diagramme RX d'un produit comparatif.

Comme indiqué plus haut le composé de l'invention présente la formule chimique (1) AₓW_{1-y}Mo_{y}O₃. Cette formule doit être interprétée comme couvrant aussi des composés légèrement sous-stoechiométriques en oxygène.

Dans cette formule, A est choisi parmi les cations Li, Na, NH₄, K et H. A peut être plus particulièrement Na ou Li.

Par ailleurs x et y vérifient les relations 0 ≤ x ≤ 1 et 0 ≤ y ≤ 0,5. Les composés de formule (1) pour laquelle y n'est pas nul correspondent à des produits dans lesquels le molybdène est en substitution du tungstène.

Selon des modes de réalisation particuliers x peut vérifier les relations suivantes 0 ≤ x ≤ 0,2 et 0,5 ≤ x ≤ 1 et dans le cas où x vérifie cette dernière relation A peut être plus particulièrement Na ou Li.

Selon trois autres modes de réalisation particuliers x est égal à 0, y est égal à 0 et x et y sont tous deux égaux à 0, respectivement.

Les valeurs de x et de y sont mesurées par la technique de spectroscopie de photoélectrons X dans le cas où A = H, NH₄ ou Li, et par la technique d'analyse dispersive en énergie de rayons X dans les autres cas.

D'une manière générale le composé de l'invention présente une structure cristalline de paramètres de maille a : 10,0(1) Å et c : 3,9(1) Å et de groupe d'espace P6/mmm. La structure contient 6 unités de WO₃ par maille.

Dans le cas particulier où x = 0,2 et A = H le composé présente une structure cristalline de paramètres de maille a : 9, 9973 Å et c : 3,9205 Å et de groupe d'espace P6/mmm.

Pour l'ensemble de la description, les caractéristiques cristallographiques ont été obtenues par analyse RX avec anticathode de cuivre.

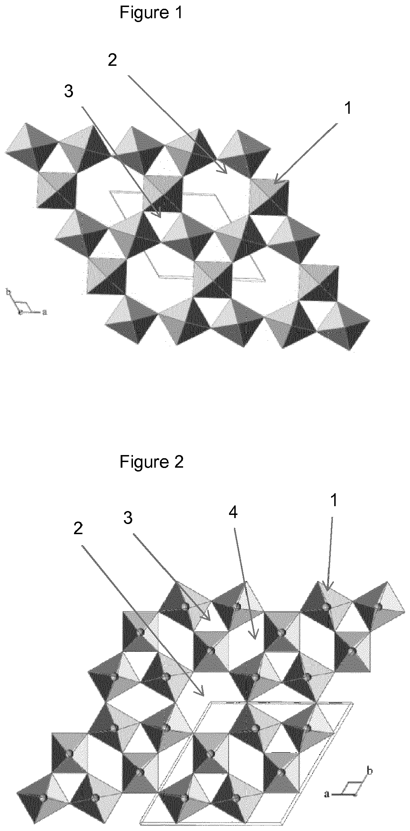

La structure cristalline de WO₃ (toutes structures confondues, c'est-à-dire celles connues et celle de l'invention) est à base d'octaèdres de WO₆ liés entre eux par les sommets. La structure hexagonale classique en particulier présente des tunnels à 3 et 6 octaèdres (Figure 1). La structure cristalline du composé de l'invention est à base d'octaèdres de WO₆ qui sont assemblés de manière à former des tunnels de 3, 4 et 6 octaèdres (Figure 2). Les figures 1 et 2 montrent ces structures hexagonales constituées d'arrangements d'octaèdres (1) de WO_{6.}

Selon une caractéristique nouvelle des composés de l'invention, la structure présente un ensemble de trois types de tunnels, c'est-à-dire des tunnels délimités respectivement par 6, 4 et 3 octaèdres de WO₆. La présence de ces trois types de tunnels apparait sur la figure 2 qui montre les tunnels (2), (3) et (4) qui sont délimités respectivement par 6, 3 et 4 octaèdres.

La figure 1 ne fait apparaitre que des tunnels (2) et (3) délimités par 6 ou 3 octaèdres seulement.

La nouvelle structure a pour effet d'ajouter des tunnels à 4 octaèdres (4), en conservant les tunnels à 3 et 6 octaèdres. A titre d'exemple, le diamètre des tunnels à 6 octaèdres est de 2,6(1) Å, cette valeur étant calculée en tenant compte de la taille des anions d'oxygène.

Selon une autre caractéristique du produit de l'invention, celui-ci est composé de particules en forme de plaquettes de 50 à 500 nm, plus particulièrement de 50 à 100 nm de diamètre, et de 2 à 50 nm, plus particulièrement de 5 à 10 nm, d'épaisseur. Cette forme et les dimensions des particules peuvent être mises en évidence par microscopie électronique par transmission (MET).

Il faut noter aussi que les tunnels, orientés selon l'axe c, se trouvent situés dans l'épaisseur des plaquettes (perpendiculaires à la face basale des particules).

Le composé présente une surface spécifique comprise entre 10 et 200 m²/g, plus particulièrement d'au moins 50 m²/g et qui peut être par exemple de 55 m²/g.

On entend par surface spécifique, la surface spécifique B.E.T. déterminée par adsorption d'azote conformément à la norme ASTM D 3663-78 établie à partir de la méthode BRUNAUER - EMMETT- TELLER décrite dans le périodique "The Journal of the American Chemical Society, 60, 309 (1938)".

Le procédé de préparation du composé de l'invention va maintenant être décrit.

Ce procédé est caractérisé en ce qu'il comprend les étapes suivantes :
- (a) on met en présence une solution aqueuse d'un sel de W (VI) et, le cas échéant d'un sel de Mo(VI), avec un agent réducteur;
- (b) on ajuste le pH du milieu obtenu à l'issue de l'étape précédente à une valeur d'au plus 7, ce par quoi on obtient une suspension, un cation A étant introduit dans une des étapes (a) ou (b);
- (c) on fait subir un mûrissement à la suspension obtenue à l'issue de l'étape (b);
- (d) on chauffe le milieu obtenu à l'issue de l'étape (c);
- (e) on sépare le solide du milieu issu de l'étape précédente et on le sèche, ce par quoi on obtient un composé AₓW_{1-y}Mo_{y}O₃ pour lequel x > 0;
- (f) éventuellement on élimine le cation A du composé obtenu à l'issue de l'étape (e), ce par quoi on obtient le composé W_{1-y}Mo_{y}O₃.

La première étape du procédé de l'invention consiste à former un mélange d'une solution aqueuse d'un sel de tungstate VI avec un agent réducteur. Ce sel peut être un tungstate alcalin comme le tungstate de sodium.

Dans le cas de la préparation d'un composé selon la formule (1) dans laquelle y n'est pas nul, le mélange de l'étape (a) comprend en outre un sel de molybdène qui peut être aussi un molybdate alcalin.

L'agent réducteur peut être choisi parmi l'hydrazine, les sucres comme le glucose et les ascorbates, par exemple l'ascorbate de sodium. La quantité de réducteur introduite est au moins le double de la quantité d'ions métalliques (W(VI)+Mo(VI)).

Dans une deuxième étape du procédé, étape (b), on ajuste le pH du milieu ou du mélange obtenu à l'issue de l'étape précédente à une valeur d'au plus 7. Cette valeur peut être plus particulièrement d'au plus 2 et elle peut être encore plus particulièrement comprise entre 1 et 2. Cet ajustement du pH peut être effectué par ajout d'un acide, l'acide chlorhydrique par exemple.

Un cation A doit être introduit dans l'une des étapes (a) et (b). Lorsque A est Li, Na, K ou NH₄, ce cation peut être introduit dans l'étape (a) par l'intermédiaire du sel de tungstène et/ou de molybdène, en utilisant un sel de ce et/ou ces éléments et du cation A, le tungstate de potassium par exemple. Le cation A lorsque A est Li, Na, K ou NH₄ peut aussi être introduit par l'intermédiaire de l'agent réducteur, l'ascorbate de sodium par exemple ou encore par l'intermédiaire d'un sel contenant A lorsque A est H.

Le cation A peut être introduit aussi à l'étape (b) du procédé par le proton de l'acide utilisé pour ajuster le pH.

La troisième étape du procédé est une étape de mûrissement de la suspension obtenue à l'issue de l'étape précédente (b).

Généralement ce mûrissement se fait à une température d'au plus 80°C. La durée de ce murissement est d'autant plus faible que la température est élevée. Selon un mode préférentiel ce mûrissement se fait à température ambiante (20°C-25°C), par exemple sur une durée de 12 heures.

Dans l'étape suivante du procédé, étape (d), on chauffe le milieu obtenu à l'issue du mûrissement à une température d'au moins 95°C, plus particulièrement d'au moins 120°C et encore plus particulièrement d'au moins 200°C, notamment dans le cas où l'agent réducteur est choisi parmi les sucres. La durée du chauffage est généralement d'autant plus longue que la température de chauffage est basse. A titre d'exemple, cette durée peut être d'au moins 12 heures pour une température de 120°C et d'au moins 3 jours pour une température de 95°C.

Ce chauffage se fait généralement sous air.

A l'issue du chauffage on sépare le solide du milieu obtenu par tout moyen connu. Ce solide est séché sous vide ou sous air, éventuellement après un lavage.

A l'issue du séchage on obtient un composé selon l'invention sous forme réduite, c'est-à-dire un composé de formule (1) dans laquelle x > 0 et donc un composé comprenant le cation A.

Le procédé de préparation de l'invention comprend une étape supplémentaire pour obtenir le composé sous forme stoechiométrique, c'est-à-dire un composé de formule (1) dans laquelle x = 0 et donc un composé sans cation A.

Cette étape supplémentaire, étape (f), peut être réalisée selon différentes variantes.

L'étape (f) peut être tout d'abord un chauffage sous air, notamment à une température comprise entre 70°C et 400°C pendant au moins 2 heures, dans le cas où A est NH₄ ou H.

Dans le cas où A est Li, Na, K, NH₄ ou H, cette étape supplémentaire peut consister à faire subir une oxydation électrochimique au composé obtenu précédemment.

Cette oxydation peut être réalisée en déposant le composé sous forme réduite et sous forme de poudre sur un substrat conducteur qui sert d'électrode. Cette électrode est plongée dans un électrolyte dans lequel est plongée aussi une contre-électrode, en platine par exemple. On applique alors une différence de potentiel entre les deux électrodes de façon à ce que le potentiel de l'électrode sur laquelle a été déposé le composé soit supérieur à 0V par rapport à l'électrode standard à hydrogène.

Selon une troisième variante de cette étape supplémentaire et dans le cas où A est Li, Na, K ou NH₄, un échange ionique peut alors être effectué, notamment en redispersant le composé sous forme réduite dans un milieu aqueux acide à pH ≤ 1, pour remplacer Li, Na, K ou NH₄ par H. Le composé alors obtenu est de formule (1) où A est H. Ce composé est alors traité par l'une des méthodes citées ci-dessus, à savoir le chauffage sous air ou l'oxydation électrochimique.

Des exemples vont maintenant être donnés.

### EXEMPLE 1

Cet exemple concerne la préparation d'un composé selon l'invention sous forme réduite et pour lequel A = H et sous forme stoechiométrique.

On forme un mélange d'une solution stable de tungstate de sodium Na₂W^{IV}O₄.2H₂O (0,15 mol/L) avec de l'hydrazine (2,5 équivalents). Le pH est ajusté à 1,3 avec de l'acide chlorhydrique. On obtient une suspension d'un composé blanc qui est maintenue à température ambiante (25°C) pendant 12 heures pour mûrissement. On chauffe ensuite la suspension à 95°C ce par quoi on obtient une suspension d'un produit bleu foncé. Le chauffage est maintenu à cette température pendant 3 jours. Le produit solide est ensuite lavé à l'eau distillée par centrifugation et séché. Il répond à la formule H_{0,1}WO₃.

Le produit séché est chauffé ensuite 12 h à 100°C sous air. On obtient ainsi un composé de formule WO₃.

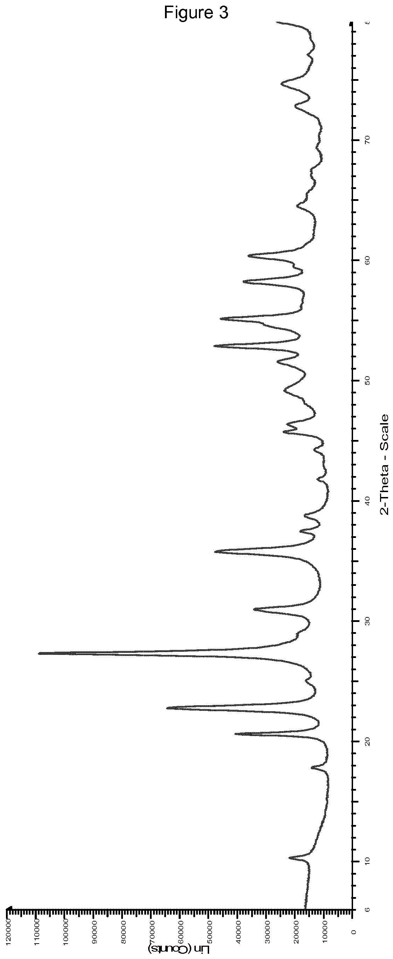

Les deux produits après séchage et après chauffage présentent le même diagramme RX donné à la figure 3. Ce diagramme RX met en évidence la structure avec les trois types de tunnels décrits précédemment.

### EXEMPLE 2

On procède comme dans l'exemple 1 mais le chauffage de la suspension est conduit à 120°C pendant 12 heures. On obtient les mêmes produits que dans l'exemple 1.

### EXEMPLE 3

On procède comme dans l'exemple 1 mais en utilisant de l'ascorbate de sodium (3 équivalents) comme réducteur. En outre le chauffage de la suspension est conduit à 220°C pendant 12 heures. On obtient les mêmes produits que dans l'exemple 1.

### EXEMPLE 4

On procède comme dans l'exemple 1 mais en utilisant du glucose (3 équivalents) comme réducteur. On obtient les mêmes produits que dans l'exemple 1.

### EXEMPLE 5 COMPARATIF

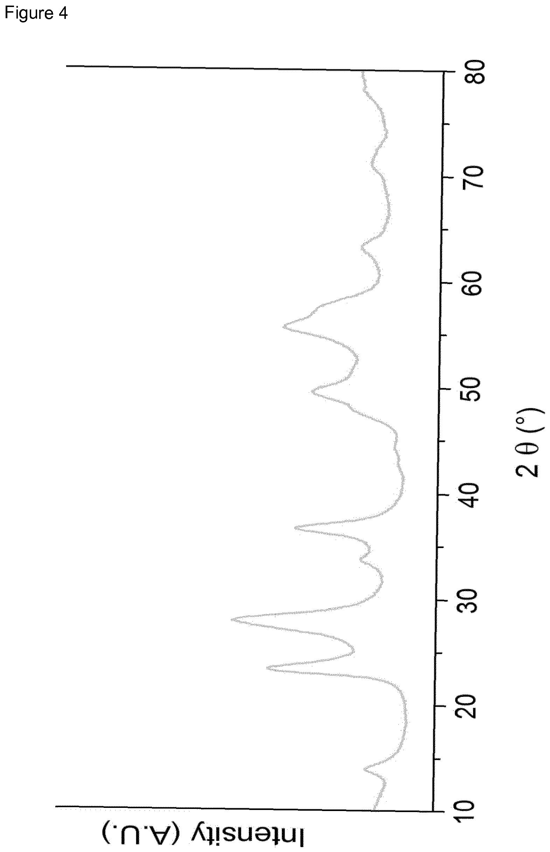

On procède comme dans l'exemple 1. Cependant la suspension obtenue après l'ajustement du pH est chauffée directement à 95°C pendant 3 jours sans mûrissement. On obtient après séchage un produit de formule (NH₄)_{0,1}WO₃ de structure hexagonale dont le diagramme de diffraction des rayons X à la longueur d'onde Kα du cuivre est présenté à la figure 4, décrit dans l'art antérieur dont les paramètres de maille sont a = 7,3(1) et c = 3,9(1) et correspondant à une structure présentant les deux types de tunnels (2) et (3) de la figure 1. On constate que l'absence de mûrissement conduit à la présence de NH₄ dans le produit obtenu.

## Revendications

1. Composé de formule (1) AₓW_{1-y}Mo_{y}O₃ dans laquelle A est choisi dans le groupe comprenant les cations Li, Na, NH₄, K et H, et il est **caractérisé en ce que** x et y vérifient les relations 0 ≤ x ≤ 1 et 0 ≤ y ≤ 0,5 et **en ce qu'**il présente une structure cristalline de type hexagonal et à base d'octaèdres WO₆, ladite structure présentant des tunnels délimités par 6, 4 et 3 desdits octaèdres et orientés selon l'axe c.

2. Composé selon la revendication 1, **caractérisé en ce qu'**il répond à la formule (1) dans laquelle x vérifie la relation 0 ≤ x ≤ 0,2.

3. Composé selon la revendication 1, **caractérisé en ce qu'**il répond à la formule (1) dans laquelle x vérifie la relation 0,5 ≤ x ≤ 1.

4. Composé selon la revendication 1 ou 2, **caractérisé en ce qu'**il répond à la formule (1) dans laquelle x et/ou y = 0.

5. Composé selon l'une des revendications précédentes, **caractérisé en ce qu'**il présente une structure cristalline de paramètres de maille a : 10,0(1) Å et c : 3,9(1) Å et de groupe d'espace P6/mmm.

6. Composé selon l'une des revendications précédentes, **caractérisé en ce qu'**il est composé de particules en forme de plaquettes de 50 à 500 nm de diamètre et de 2 à 50 nm d'épaisseur.

7. Procédé de préparation d'un composé selon l'une des revendications précédentes, **caractérisé en ce qu'**il comprend les étapes suivantes :
- (a) on met en présence une solution aqueuse d'un sel de W (VI) et, le cas échéant d'un sel de Mo(VI), avec un agent réducteur;
- (b) on ajuste le pH du milieu obtenu à l'issue de l'étape précédente à une valeur d'au plus 7, ce par quoi on obtient une suspension, un cation A étant introduit dans une des étapes (a) ou (b);
- (c) on fait subir un mûrissement à la suspension obtenue à l'issue de l'étape (b);
- (d) on chauffe le milieu obtenu à l'issue de l'étape (c);
- (e) on sépare le solide du milieu issu de l'étape précédente et on le sèche, ce par quoi on obtient un composé AₓW_{1-y}Mo_{y}O₃ pour lequel x > 0;
- (f) éventuellement on élimine le cation A du composé obtenu à l'issue de l'étape (e), ce par quoi on obtient le composé W_{1-y}Mo_{y}O₃.

8. Procédé selon la revendication 7, **caractérisé en ce qu'**on utilise pour l'étape (a) un sel de tungstène et du cation A.

9. Procédé selon la revendication 7 ou 8, **caractérisé en ce que** lors de l'étape (b) on on ajuste le pH à une valeur d'au plus 2, plus particulièrement comprise entre 1 et 2.

10. Procédé selon l'une des revendications 7 à 9, **caractérisé en ce qu'**on effectue le mûrissement de l'étape (c) à une température d'au plus 80°C, plus particulièrement à température ambiante.

11. Procédé selon l'une des revendications 7 à 10, **caractérisé en ce qu'**on effectue l'étape (d) en chauffant à une température d'au moins 95°C, plus particulièrement d'au moins 120°C.

12. Procédé selon l'une des revendications 7 à 11, **caractérisé en ce qu'**on utilise à l'étape (a) un agent réducteur choisi parmi l'hydrazine, les sucres et les ascorbates.

13. Procédé selon l'une des revendications 7 à 12, **caractérisé en ce que** A est NH₄ ou H et **en ce que** l'étape (f) est une étape de chauffage sous air.

14. Procédé selon l'une des revendications 7 à 12, **caractérisé en ce que** A est Li, Na, K, NH₄ ou H et **en ce que** l'étape (f) est une oxydation électrochimique.

15. Procédé selon l'une des revendications 7 à 12, **caractérisé en ce que** A est Li, Na, K, NH₄ et **en ce que** l'étape (f) comprend un échange ionique pour remplacer Li, Na, K ou NH₄ par H puis un chauffage sous air ou une oxydation électrochimique du composé issu de l'échange ionique.

## Patentansprüche

1. Verbindung mit der Formel (1) AₓW_{1-y}Mo_{y}O₃, wobei A ausgewählt ist aus der Gruppe umfassend Kationen Li, Na, NH₄, K und H, und wobei diese **dadurch gekennzeichnet ist, dass** x und y die Beziehungen 0 ≤ x ≤ 1 und 0 ≤ y ≤ 0,5 erfüllen, und dadurch, dass diese eine kristalline Struktur des hexagonalen Typs und auf der Basis von Oktaedern WO₆ aufweist, wobei die Struktur Tunnel aufweist, die von 6, 4 und 3 der Oktaeder begrenzt sind und gemäß der Achse c ausgerichtet sind.

2. Verbindung nach Anspruch 1, **dadurch gekennzeichnet, dass** diese die Formel (1) aufweist, wobei x die Beziehung 0 ≤ x ≤ 0,2 erfüllt.

3. Verbindung nach Anspruch 1, **dadurch gekennzeichnet, dass** diese die Formel (1) aufweist, wobei x die Beziehung 0,5 ≤ x ≤ 1 erfüllt.

4. Verbindung nach Anspruch 1 oder 2, **dadurch gekennzeichnet, dass** diese die Formel (1) aufweist, wobei x und/oder y = 0.

5. Verbindung nach einem der vorhergehenden Ansprüche, **dadurch gekennzeichnet, dass** diese eine kristalline Struktur mit Gitterparametern a: 10,0(1) Å und c: 3,9(1) Å und einer Raumgruppe P6/mmm aufweist.

6. Verbindung nach einem der vorhergehenden Ansprüche, **dadurch gekennzeichnet, dass** diese aus Partikeln in der Form von Plättchen mit einem Durchmesser von 50 bis 500 nm und mit einer Dicke von 2 bis 50 nm besteht.

7. Verfahren zur Herstellung einer Verbindung nach einem der vorhergehenden Ansprüche, **dadurch gekennzeichnet, dass** dieses die folgenden Schritte umfasst:
(a) eine wässrige Lösung eines Salzes von W (VI) und gegebenenfalls eines Salzes von Mo (VI) wird mit einem Reduktionsmittel zusammengeführt;
(b) der pH des am Ende des vorhergehenden Schritts erhaltenen Mediums wird auf einen Wert von höchstens 7 eingestellt, wodurch eine Suspension erhalten wird, wobei ein Kation A in einem der Schritte (a) oder (b) eingebracht wird;
(c) die am Ende von Schritt (b) erhaltene Suspension wird einer Reifung unterworfen;
(d) das am Ende von Schritt (c) erhaltene Medium wird erhitzt;
(e) der Feststoff wird vom aus dem vorhergehenden Schritt erhaltenen Medium abgetrennt und getrocknet, wodurch eine Verbindung AₓW_{1-y}Mo_{y}O₃ erhalten wird, wobei x > 0;
(f) das Kation A wird gegebenenfalls aus der am Ende von Schritt (e) erhaltenen Verbindung eliminiert, wodurch die Verbindung W_{1-y}Mo_{y}O₃ erhalten wird.

8. Verfahren nach Anspruch 7, **dadurch gekennzeichnet, dass** für Schritt (a) ein Wolframsalz und das Kation A verwendet werden.

9. Verfahren nach Anspruch 7 oder 8, **dadurch gekennzeichnet, dass** während des Schritts (b) der pH auf einen Wert von höchstens 2, bevorzugter zwischen 1 und 2, eingestellt wird.

10. Verfahren nach einem der Ansprüche 7 bis 9, **dadurch gekennzeichnet, dass** die Reifung von Schritt (c) bei einer Temperatur von höchstens 80°C, bevorzugter bei Umgebungstemperatur, durchgeführt wird.

11. Verfahren nach einem der Ansprüche 7 bis 10, **dadurch gekennzeichnet, dass** der Schritt (d) durch Erhitzen auf eine Temperatur von mindestens 95°C, bevorzugter mindestens 120°C, durchgeführt wird.

12. Verfahren nach einem der Ansprüche 7 bis 11, **dadurch gekennzeichnet, dass** im Schritt (a) ein Reduktionsmittel, ausgewählt aus Hydrazin, Zuckern und Ascorbaten, verwendet wird.

13. Verfahren nach einem der Ansprüche 7 bis 12, **dadurch gekennzeichnet, dass** A NH₄ oder H ist, und dadurch, dass der Schritt (f) ein Schritt des Erhitzens unter Luft ist.

14. Verfahren nach einem der Ansprüche 7 bis 12, **dadurch gekennzeichnet, dass** A Li, Na, K, NH₄ oder H ist, und dadurch, dass der Schritt (f) eine elektrochemische Oxidation ist.

15. Verfahren nach einem der Ansprüche 7 bis 12, **dadurch gekennzeichnet, dass** A Li, Na, K, NH₄ ist, und dadurch, dass der Schritt (f) einen Ionenaustausch, um Li, Na, K oder NH₄ durch H zu ersetzen, und anschließend ein Erhitzen unter Luft oder eine elektrochemische Oxidation der aus dem Ionenaustausch erhaltenen Verbindung umfasst.

## Claims

1. Compound of formula (1) AₓW_{1-y}Mo_{y}O₃ wherein A is selected from the group consisting of the Li, Na, NH₄, K and H cations, and it is **characterized in that** x and y confirm the relationships 0 ≤ x ≤ 1 and 0 ≤ y ≤ 0.5 and **in that** it has a crystalline structure of hexagonal type which is based on WO₆ octahedra, said structure having tunnels delimited by 6, 4 and 3 of said octahedra and oriented along the axis c.

2. Compound according to Claim 1, **characterized in that** it corresponds to formula (1) wherein x confirms the relationship 0 ≤ x ≤ 0.2.

3. Compound according to Claim 1, **characterized in that** it corresponds to formula (1) wherein x confirms the relationship 0.5 ≤ x ≤ 1.

4. Compound according to Claim 1 or 2, **characterized in that** it corresponds to formula (1) wherein x and/or y = 0.

5. Compound according to one of the preceding claims, **characterized in that** it has a crystalline structure with lattice parameters a: 10.0(1) Å and c: 3.9(1) Å and space group P6/mmm.

6. Compound according to one of the preceding claims, **characterized in that** it is composed of particles in the shape of platelets of from 50 to 500 nm in diameter and from 2 to 50 nm thick.

7. Process for preparing a compound according to one of the preceding claims, **characterized in that** it comprises the following steps:
- (a) an aqueous solution of a salt of W (VI) and, where appropriate, of a salt of Mo(VI), is brought into contact with a reducing agent;
- (b) the pH of the medium obtained at the end of the preceding step is adjusted to a value of at most 7, as a result of which a suspension is obtained, a cation A being introduced in one of steps (a) or (b);
- (c) the suspension obtained at the end of step (b) is subjected to maturing;
- (d) the medium obtained at the end of step (c) is heated;
- (e) the solid is separated from the medium resulting from the preceding step and is dried, as a result of which a compound AₓW_{1-y}Mo_{y}O₃ for which x > 0 is obtained;
- (f) optionally, the cation A is eliminated from the compound obtained at the end of step (e), as a result of which the compound W_{1-y}Mo_{y}O₃ is obtained.

8. Process according to Claim 7, **characterized in that** a salt of tungsten and of the cation A is used for step (a).

9. Process according to Claim 7 or 8, **characterized in that**, during step (b), the pH is adjusted to a value of at most 2, more particularly of between 1 and 2.

10. Process according to one of Claims 7 to 9, **characterized in that** the maturing of step (c) is carried out at a temperature of at most 80°C, more particularly at ambient temperature.

11. Process according to one of Claims 7 to 10, **characterized in that** step (d) is carried out by heating at a temperature of at least 95°C, more particularly of at least 120°C.

12. Process according to one of Claims 7 to 11, **characterized in that** a reducing agent selected from hydrazine, sugars and ascorbates is used in step (a).

13. Process according to one of Claims 7 to 12, **characterized in that** A is NH₄ or H and **in that** step (f) is a step of heating under air.

14. Process according to one of Claims 7 to 12, **characterized in that** A is Li, Na, K, NH₄ or H and **in that** step (f) is an electrochemical oxidation.

15. Process according to one of Claims 7 to 12, **characterized in that** A is Li, Na, K or NH₄ et and **in that** step (f) comprises an ion exchange so as to replace Li, Na, K or NH₄ with H and then heating under air or electrochemical oxidation of the compound resulting from the ion exchange.
